# EUROPEAN PATENT APPLICATION

(11) **EP 4 417 866 A1**
(43) Date of publication of application: **21.08.2024**
(21) Application number: 23175533.1
(22) Date of filing: 26.05.2023
(51) Int. Cl.: F21V 23/00, F21K 9/00, F21Y 115/10, F21Y 103/10

(54) **LIGHT-STRUCTURE CONNECTION DEVICE AND SYSTEM**

(30) Priority: 17.02.2023 CN 202320249398 U
(71) Applicant: Shangyou Jiayi Lighting Product Co., Ltd., Huangbu Town, Shangyou County Ganzhou City Jiangxi 314000 (CN)
(72) Inventor: HE, Yaowen, Ganzhou City, 341316 (CN)
(74) Representative: Berggren Oy

(57) **Abstract**

The present disclosure provides a light-structure connection device and system, which relate to the technical field of light string control, comprising: a light structure and a power source structure, wherein the light structure and the power source structure are electrically connected; the light structure comprises a plurality of LED brackets, and each LED bracket comprises a plurality of bonding pads and a plurality of light-emitting chips, wherein the bonding pads are electrically connected to the light-emitting chips. The bonding pads are configured to provide wiring interfaces for the light-emitting chip so that electric energy provided by the power supply structure is transmitted to the light-emitting chip through the wiring interfaces; and the power source structure is configured to supply power to the light-emitting chip. The present disclosure provides portable wiring interfaces for the light-emitting chip through the LED bracket, which can significantly reduce the complexity of the circuit and improve user experience.

## Description

### Technical Field

The present disclosure relates to the technical field of light string control, in particular to a light-structure connection device and system.

### Background Art

LED string combines with a certain number of LED light-emitting chips in the wires by series and parallel connection, so that a whole light string receives the required voltage. Currently, the relative technology presents that when connecting different light strings to each other, an additional return cable is needed to connect the positive end to the tail end of the light string or the negative end to the front end of the light string through the return cable. This solution will increase the complexity of the circuit when connecting a large number of light strings, raising the cost and causing inconvenience to the connection operation.

### Summary

In view of this, the objective of the present disclosure is to provide a light-structure connection device and system. By providing a portable wiring interface by the LED bracket for the light-emitting chip, the complexity of the circuit can be significantly reduced, which enhances the user experience.

In the first aspect, the embodiment of the present disclosure provides a light-structure connection device, wherein it comprises a light structure and a power source structure, wherein the light structure and the power source structure are electrically connected; and the light structure comprises a plurality of LED brackets, and each LED bracket comprises a plurality of bonding pads and a plurality of light-emitting chips, wherein the bonding pads are electrically connected to the light-emitting chips. The bonding pads are configured to provide wiring interfaces for the light-emitting chips, so that electric energy provided by the power supply structure is transmitted to the light-emitting chips through the wiring interfaces; and the power source structure is configured to supply power to the light-emitting chips.

In an embodiment, the power source structure comprises a positive connection line and a negative connection line, wherein the positive connection line and the negative connection line are configured to supply power to the LED bracket.

In an embodiment, the power source structure further comprises a signal connection line, and the signal connection line is respectively connected to the light structure and peripheral control device, for controlling the working state of the light-emitting chips.

In an embodiment, the bonding pad comprises a power supply pad, and the power supply pad is provided at the left and right ends of the LED bracket and/or is provided at the upper, lower, left, and right ends of the LED bracket, for connection with the positive connection line or the negative connection line.

In an embodiment, the bonding pad further comprises a signal pad, and the signal pad is provided at the left and right ends of the LED bracket, for the connection with the signal connection line.

In an embodiment, the LED bracket comprises a two-bonding-pad LED bracket, and the two-bonding-pad LED bracket is applied to an intermediate light-emitting chip of the light structure; and the two-bonding-pad LED bracket comprises the power supply pad provided at the left and right ends of the LED bracket, wherein the two-bonding-pad LED bracket is configured to connect each intermediate light-emitting chip in series.

In an embodiment, the LED bracket further comprises a four-bonding-pad LED bracket, and the four-bonding-pad LED bracket is applied to both ends of light-emitting chips of the light structure; and the four-bonding-pad LED bracket comprises the power supply pad provided at upper, lower, left, and right ends of the LED bracket, wherein the four-bonding-pad LED bracket is configured to enable the both ends of light-emitting chips to respectively connect to one positive connection line and one negative connection line, thus forming a closed circuit of the light structure.

In an embodiment, the four-bonding-pad LED bracket further comprises a connector, wherein the connector is configured to connect the docking light structure with the light structure to be docked.

In an embodiment, the LED bracket further comprises a protective casing, wherein the protective casing is configured to provide various appearance shapes for the light-emitting chip.

In the second aspect, the present disclosure provides a light-structure connection system, wherein it comprises the light-structure connection device of any one of the above first aspects and a peripheral control system connected to the light-structure connection device.

The embodiment of the present disclosure offers beneficial effects as follows.

The present disclosure provides a light-structure connection device and system, comprising a light structure and a power source structure, wherein the light structure and the power source structure are electrically connected; and the light structure comprises a plurality of LED brackets, and each LED bracket comprises a plurality of bonding pads and a plurality of light-emitting chips, wherein the bonding pads are electrically connected to the light-emitting chips. The bonding pads are configured to provide wiring interfaces for the light-emitting chips so that electric energy provided by the power supply structure is transmitted to the light-emitting chips through the wiring interfaces; and the power source structure is configured to supply power to the light-emitting chip. When the light-emitting chips are connected in the above device, the portable wiring interfaces, provided by the LED bracket for the light-emitting chip, can significantly reduce the complexity of the circuit and improve user experience.

Other features and advantages of the present disclosure will be set forth in the subsequent specification and, in part, become apparent from the specification or are understood by implementing the present disclosure. The objective and other advantages of the present disclosure are achieved and obtained in the structure specifically indicated in the specification, the claims, and the accompanying drawings.

In order to make the above objective, features, and advantages of the present disclosure more obvious and easier to understand, the following is a better example, with the attached drawings, for detailed description as follows.

### Brief Description of Drawings

In order to more clearly illustrate the specific embodiments of the present disclosure or the technical solution in the prior art, the drawings required to be used in the description of the specific embodiment or prior art will be briefly introduced as follows. Obviously, the drawings described below are some embodiments of the present disclosure, and those of ordinary skill in the art, without paying inventive effort, may also obtain other drawings according to these drawings.
FIG. 1 is a schematic view of the structure of connection of multiple light strings provided by the embodiment of the present disclosure;
FIG. 2 is a schematic view of the structure of a light-structure connection device provided by the embodiment of the present disclosure;
FIG. 3 is a schematic structural view of an LED bracket according to an embodiment of the present disclosure;
FIG. 4 is a schematic structural view of another LED bracket according to an embodiment of the present disclosure;
FIG. 5 is a schematic view of another structure of connection of multiple light strings provided by the embodiment of the present disclosure; and
FIG. 6 is a schematic view of the structure of a light-structure connection system provided by the embodiment of the present disclosure.

### Detailed Description of Embodiments

In order to make the objectives, the technical solutions and the advantages of the embodiments of the present disclosure clearer, clear and complete description of the technical solutions of the present disclosure will be given below in conjunction with embodiments that are clearly part of and not all of the embodiments of the present disclosure. Based on the embodiments in the present disclosure, all other embodiments obtained by those of ordinary skill in the art without making inventive efforts are within the scope of protection of the present disclosure.

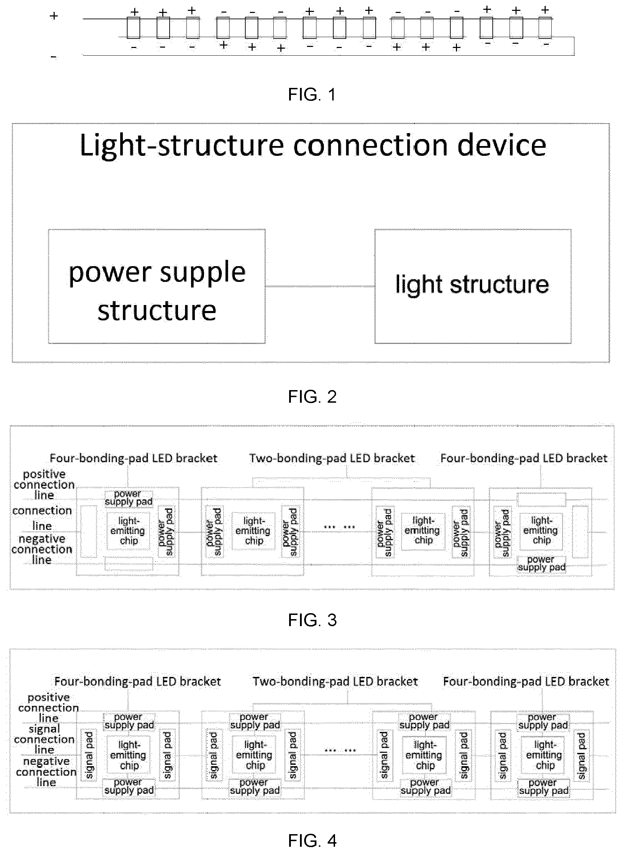

At present, the LED string combines with a certain number of LED light-emitting chips in the wires by series and parallel connection, so that a whole light string receives the required voltage. Referring to the schematic view of the structure of connection of multiple light strings shown in FIG. 1, when a number of different light structures (light strings) are docked, the return cables need to be added to form dockable products. When connecting different light strings to each other, an additional return cable is needed to connect the positive end to the tail end of the light string through the return cable. This solution requires multiple cables to complete the docking of product when the number of connected light strings is large, which will enhance the complexity of the circuit, raise the cost, and cause inconvenience to the connection operation. In view of this, the present disclosure provides a light-structure connection device. By providing a portable wiring interface by the LED bracket for the light-emitting chip, the light-emitting chips can be soldered directly into the wires to form a series-parallel circuit, without adding a return cable to form a dockable product. Therefore, the complexity of the circuit is significantly reduced, which enhances the user experience.

In order to facilitate the understanding of this embodiment, firstly, a light-structure connection device provided in the embodiment of the present disclosure is described in detail.

Referring to a schematic view of the structure of a light-structure connection device shown in FIG. 2, the present disclosure provides a light-structure connection device, comprising a light structure and a power source structure, wherein the light structure and the power source structure are electrically connected; the light structure comprises a plurality of LED brackets, and each LED bracket comprises a plurality of bonding pads and a plurality of light-emitting chips, wherein the bonding pads are electrically connected to the light-emitting chips. The bonding pads are configured to provide wiring interfaces for the light-emitting chips, so that electric energy provided by the power supply structure is transmitted to the light-emitting chip through the wiring interfaces; and the power source structure is configured to supply power to the light-emitting chip. In an embodiment, the power source structure comprises a signal connection line, a positive connection line, and a negative connection line, wherein the signal connection line is respectively connected to the light structure and a peripheral control device, for controlling the working state of the light-emitting chip, and the positive connection line and negative connection line are configured to supply power to the LED bracket. The light-emitting chip can work normally by the simultaneous action of the signal connection line, the positive connection line, and the negative connection line. The bonding pad is the soldering point for the wire and the light-emitting chip, wherein except for the bonding pad, the rest of the positions in the frame of the LED bracket can also be soldered.

In the light-structure connection device and system provided in the embodiment of the present disclosure, when connecting multiple light strings, a portable wiring interface is provided by the LED bracket for the light-emitting chip. Therefore, the complexity of the circuit can be significantly reduced, which enhances the user experience.

In addition, a schematic view of the structure of an LED bracket is shown in FIG. 3. The LED bracket comprises a plurality of bonding pads and a plurality of light-emitting chips, and a bonding pad comprises a power supply pad and a signal pad. The power supply pad is provided at the left and right ends of the LED bracket and/or is provided at the upper, lower, left, and right ends of the LED bracket, for connection with the positive connection line or the negative connection line. The signal pad is provided at the left and right ends of the LED bracket, for the connection with the signal connection line. In an embodiment, the LED bracket comprises a two-bonding-pad LED bracket and a four-bonding-pad LED bracket. The two-bonding-pad LED bracket is applied to an intermediate light-emitting chip of the light structure, comprising the power supply pad arranged at the left and right ends of the LED bracket, wherein the two-bonding-pad LED bracket is configured to connect each intermediate light-emitting chip in series. The four-bonding-pad LED bracket is applied to both ends of light-emitting chips of the light structure. The four-bonding-pad LED bracket comprises the power supply pad provided at the upper, lower, left, and right ends of the LED bracket, wherein the four-bonding-pad LED bracket is configured to enable the both ends of light-emitting chips to connect to one positive connection line and one negative connection line, thus forming a closed circuit of the light structure. In an embodiment, within the same light string, the LED bracket of the intermediate light-emitting chip is only connected to the signal connection line, which can be subsequently changed to other sizes of LED lights. If the front-most light-emitting chip is connected to the positive connection line and the signal connection line, the last light-emitting chip is connected to the negative connection line and the signal line; and if the front-most light-emitting chip is connected to the negative connection line and the signal connection line, the last light-emitting chip is connected to the positive connection line and the signal line. Thus, a closed circuit is formed. If both ends of light-emitting chips of two interconnected light strings are wired the same way, the two light strings are connected in parallel. The four-bonding-pad LED bracket is also able to be applied to the intermediate light-emitting chip, however, when the four-bonding-pad LED bracket is configured to the intermediate light-emitting chip, the power supply pad in the LED bracket cannot be functional.

The schematic view of another structure of the LED bracket is shown in FIG. 4. For light beads with the demand of signal transmission, it is necessary to connect the signal pads at the left and right ends of each LED bracket by the signal connection line. In an embodiment, in the middle light bead and the two-end light bead of the light structure, the number and position of power supply pads are different. However, the number and position of signal pads are the same, which are both arranged at the left and right ends of the LED bracket and are connected to the signal connection line.

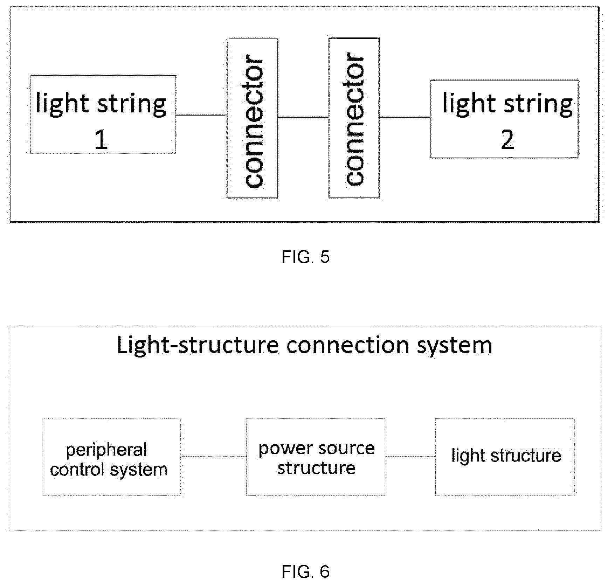

Referring to FIG. 5, which is a schematic view of another structure of connection of multiple light strings, the four-bonding-pad LED bracket further comprises a connector. The connector is configured to connect the docking light structure with the light structure to be docked. That is to say, after connecting the butt joints of the connectors in different light strings, the connection between the docking light structure and the light structure to be docked can be achieved. In an embodiment, the LED bracket further comprises a protective casing, wherein the protective casing is configured to provide various appearance shapes for the light-emitting chip. After connecting the light structure (light string) as a finished product, the light string can be bent and stuffed into the inside of the protective casing, and can be fixed by gluing, thus shaping the light string as a whole.

For the light-structure connection device provided in the preceding embodiment, the embodiment of the present disclosure also provides a light-structure connection system, which is shown in FIG. 6 as the structural schematic diagram of a light-structure connection system. The system comprises the light-structure connection device provided in the preceding embodiment and a peripheral control system connected to the light-structure connection device. By using three wires, it is possible to form a series-parallel connection of light-emitting chips and to dock different light strings (different light structure products) with each other.

In the light-structure connection device and system provided in the embodiment of the present disclosure, when connecting multiple light strings, a portable wiring interface is provided by the LED bracket for the light-emitting chip. Therefore, the complexity of the circuit can be significantly reduced, which enhances the user experience.

It will be clear to those skilled in the art that, for the convenience and brevity of the description, the specific working processes of the light-structure connection device described above can be referred to the corresponding processes in the preceding embodiments and will not be repeated here.

In the description of embodiments of the present disclosure, unless otherwise clearly stipulated and limited, the terms "install", "link" and "connect" should be understood in a broad sense, for example, it can be a fixed connection, a detachable connection, or an integral connection, it can be a mechanical connection, or an electrical connection, and it can be a direct connection, an indirect connection through an intermediary, or an internal communication between two components. Those of ordinary skill in the art can understand the specific meanings of the above terms in the present disclosure according to specific situations.

In the description of the present disclosure, it should be noted that the terms "center", "up", "down", "left", "right", "vertical", "horizontal", "inside", "outside", etc. indicate an orientation or positional relationship based on the orientation or positional relationship shown in the accompanying drawings and are intended only to facilitate and simplify the description of the present disclosure, which are not to indicate or imply that the device or element referred to must be in a particular orientation, or constructed and operated in a particular orientation, and therefore are not to be construed as limiting the present disclosure. In addition, the terms "first", "second" and "third" are used for descriptive purposes only and are not to be construed as indicating or implying relative importance.

Finally, it should be noted that the above embodiments are only used to illustrate the technical solution of the present disclosure, not to limit it; while the present disclosure has been described in detail with reference to the preceding embodiments. It will be understood by those of ordinary skill in the art that, one may still modify the technical solution described in the preceding embodiments, or replace some or all of the technical features equally; and these modifications or substitutions do not depart the essence of the corresponding technical solution from the scope of the technical solution of the embodiments of the present disclosure.

## Claims

1. A light-structure connection device, wherein the light-structure connection device comprises: a light structure and a power source structure, wherein the light structure and the power source structure are electrically connected;
the light structure comprises a plurality of LED brackets, and each LED bracket comprises a plurality of bonding pads and a plurality of light-emitting chips, wherein the bonding pads are electrically connected to the light-emitting chips; the bonding pads are configured to provide wiring interfaces for the light-emitting chips, so that electric energy provided by the power supply structure is transmitted the light-emitting chips through the wiring interfaces; and
the power source structure is configured to supply power to the light-em itting chip.

2. The light-structure connection device according to claim 1, wherein the power source structure comprises: a positive connection line and a negative connection line, wherein
the positive connection line and the negative connection line are configured to supply power to the LED brackets.

3. The light-structure connection device according to claim 2, wherein the power source structure further comprises a signal connection line, and
the signal connection line is respectively connected to the light structure and a peripheral control device, for controlling a working state of the light-emitting chips.

4. The light-structure connection device according to any one of claims 2 to 3, wherein the bonding pads comprise power supply pads, and
the power supply pads are provided at left and right ends of the LED brackets and/or are provided at upper, lower, left, and right ends of the LED brackets, for connection with the positive connection line or the negative connection line.

5. The light-structure connection device according to claim 4, wherein the bonding pads further comprise signal pads, and
the signal pads are provided at the left and right ends of the LED brackets, for connection with the signal connection line.

6. The light-structure connection device according to claim 4, wherein the LED brackets comprise two-bonding-pad LED brackets, and the two-bonding-pad LED brackets are applied to intermediate light-emitting chips of the light structure; and the two-bonding-pad LED brackets comprise the power supply pads provided at the left and right ends of the LED brackets, wherein the two-bonding-pad LED brackets are configured to connect each intermediate light-emitting chip in series.

7. The light-structure connection device according to claim 6, wherein the LED brackets further comprise four-bonding-pad LED brackets, and the four-bonding-pad LED brackets are applied to both ends of light-emitting chips of the light structure; and the four-bonding-pad LED brackets comprise the power supply pads provided at the upper, lower, left, and right ends of the LED brackets, wherein
the four-bonding-pad LED brackets are configured to enable the both ends of light-emitting chips to respectively connect to one positive connection line and one negative connection line, thus forming a closed circuit of the light structure.

8. The light-structure connection device according to claim 7, wherein the four-bonding-pad LED brackets further comprise connectors, and
the connectors are configured to connect a docking light structure with a light structure to be docked.

9. The light-structure connection device according to claim 1, wherein the LED brackets further comprise a protective casing, and
the protective casing is configured to provide various appearance shapes for the light-emitting chips.

10. A light-structure connection system, wherein the light-structure connection system comprises: the light-structure connection device according to any one of claims 1-9, and a peripheral control system connected to the light-structure connection device.
